# EUROPEAN PATENT APPLICATION

(11) **EP 1 570 991 A2**
(43) Date of publication of application: **07.09.2005**
(21) Application number: 05004352.0
(22) Date of filing: 28.02.2005
(51) Int. Cl.: B41J 2/14

(54) **Liquid droplet ejecting apparatus und method for producing same**

(30) Priority: 02.03.2004 JP 2004057010
(71) Applicant: ENPLAS CORPORATION, Saitama 332-0034 (JP)
(72) Inventor: Yamada, Kyouhei, Saitama-shi Saitama 331-0812 (JP); Watanabe, Yasuhiro, 1188LL Amstelveen (NL)
(74) Representative: Manitz, Finsterwald & Partner GbR

(57) **Abstract**

There is provided a liquid droplet ejecting apparatus capable of being efficiently produced at low production costs. The liquid droplet ejecting apparatus 1 includes a substrate 2 which has a hole 4 extending in thickness directions to pass through the substrate 2, and a photoresist film 3 which is formed on one side 2a of the substrate 2 so as to close one end of the hole 4, the photoresist film 3 having a small hole 5 which faces the one end of the hole 4 to open the one end of the hole 4 to the atmosphere. Thus, the liquid droplet ejecting apparatus 1 is designed to eject a droplet of a liquid from the small hole 5 by applying a pressure of a pressure source 6 to the other end of the hole 4 after the liquid is injected into the hole 4.

## Description

### BACKGROUND OF THE INVENTION

### Field of the Invention

The present invention generally relates to a liquid droplet ejecting apparatus and a method for producing the same. More specifically, the invention relates to a liquid droplet ejecting apparatus for ejecting a small amount of liquid droplet (e.g., an ink or a liquid containing substances derived from biosubstances, such as DNA), and a method for producing the same.

### Description of the Prior Art

In recent years, in order to examine the functions of genes or the like, the microarray technique capable of simultaneously examining thousands kinds to tens of thousands kinds of DNA fragments has been noticed particularly in the field of genome medical science.

The microarray technique uses a DNA chip wherein various DNA fragments or the like (samples) are densely arranged on an inspection plate, such as a slide glass for microscope. In order to enhance the fabrication efficiency and determination precision of such a DNA chip, some of DNA chips are prepared by using a liquid droplet ejecting apparatus, which adapts the ink jet technique for ink jet printers, and by densely dropping a small amount of liquid sample onto an inspection plate.

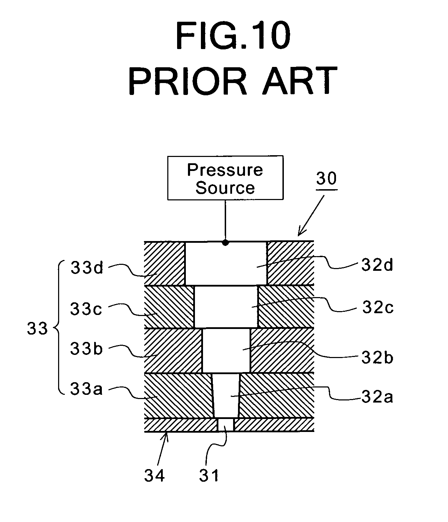

FIG. 10 shows an example of a liquid droplet ejecting apparatus 30 used for preparing a DNA chip. Such a liquid droplet ejecting apparatus 30 is designed to have a large number of nozzles 31 having a small hole size for ejecting liquid droplets. Therefore, in the liquid droplet ejecting apparatus 30, a substrate 33 having relatively large-diameter holes 32a through 32d for supplying samples, and a nozzle forming body 34 having small holes serving as the nozzles 31 are separately formed. That is, the substrate 33 is formed by stacking a plurality of ceramic plates 33a through 33d so as to align the holes 32a through 32d with each other, and then, the nozzle forming body 34 (of a plastic film, a stainless steel plate or the like) having the large number of small holes 31 is stuck on the reverse of the substrate 33 (33a) while the small holes 31 are aligned with the holes 32a of the substrate 33 (see Japanese Patent Laid-Open No. 2003-75305).

However, if the nozzle forming body 34 having the large number of nozzles 31 are stuck on the reverse of the ceramic plate 33a so that the nozzles 31 are aligned with the holes 32a of the substrate 33 as the conventional liquid droplet ejecting apparatus 30 shown in FIG. 10, there is a problem in that fabrication operation takes a great deal of time to deteriorate productivity. In addition, if the substrate 33 is formed of a ceramic plate, there is a problem in that the price of materials is high, so that production costs are high.

In order to solve such problems, it is considered that the substrate and the nozzle forming body are integrally formed by injection molding, and the holes and small holes are simultaneously formed during the injection molding. However, in such a method for integrally forming the substrate and the nozzle forming body by the injection molding, it is difficult to arrange small hole forming pins in a cavity of a die in view of the structure of the die, if the hole size of the nozzles 31 is intended to be hundreds micrometers or less.

### SUMMARY OF THE INVENTION

It is therefore an object of the present invention to eliminate the aforementioned problems and to provide a liquid droplet ejecting apparatus capable of being effectively produced at low production costs.

In order to accomplish the aforementioned and other objects, according to one aspect of the present invention, a liquid droplet ejecting apparatus comprises: a substrate having a through hole which extends in thickness directions to pass through the substrate; and a resist film formed on one side of the substrate to close one end of the through hole of the substrate, wherein the resist film has a small hole which faces the one end of the through hole to open the one end of the through hole to the atmosphere, and a droplet of a liquid is ejected from the small hole when a pressure is applied to the other end of the through hole after the liquid is injected into the through hole.

According to another aspect of the present invention, a liquid droplet ejecting apparatus comprises: a substrate having a plurality of through holes, each of which extends in thickness directions to pass through the substrate; and a plurality of lid members of a resist film, each of the lid members being formed on one side of the substrate to close one end of a corresponding one of the through holes of the substrate, wherein each of the lid members has a small hole which faces the one end of the corresponding one of the through holes to open the one end of the corresponding one of the through holes to the atmosphere, and a droplet of a liquid is ejected from the small hole of a corresponding one of the lid members when a pressure is applied to the other end of a corresponding one of the through holes after the liquid is injected into the corresponding one of the through holes.

According to a further aspect of the present invention, there is provided a method for producing a liquid droplet ejecting apparatus, the method comprising the steps of: forming a through hole in a substrate so that the through hole extends in thickness directions to pass through the substrate; forming a resist film on one side of the substrate to close one end of the through hole of the substrate; covering a portion of the resist film with a mask which has such a shape that a small hole is formed in the resist film to open the one end of the through hole to the atmosphere; exposing the resist film after the portion of the resist film is covered with the mask; and removing a portion of the resist film, which is not exposed, to form the small hole in the resist film.

According to a still further aspect of the present invention, there is provided a method for producing a liquid droplet ejecting apparatus, the method comprising the steps of: forming a plurality of through holes in a substrate so that each of the through holes extends in thickness directions to pass through the substrate; forming a resist film on one side of the substrate to close one end of each of the through holes of the substrate; covering portions of the resist film with a mask which has such a shape that a plurality of lid members of the resist film are formed to close the one end of each of the through holes, respectively, and that a plurality of small holes are formed in the lid members to open the one end of each of the through holes to the atmosphere, respectively; exposing the resist film after the portions of the resist film are covered with the mask; and removing portions of the resist film, which are not exposed, to form the small holes in the lid members, respectively.

In a liquid droplet ejecting apparatus according to the present invention, holes of a substrate serving as liquid supply ports are closed by a resist film in which a large number of small holes serving as nozzles are formed, so that the large number of small holes can be simultaneously formed with a developing solution. Therefore, it is possible to enhance the production efficiency, and it is possible to reduce the production costs.

### BRIEF DESCRIPTION OF THE DRAWINGS

The present invention will be understood more fully from the detailed description given herebelow and from the accompanying drawings of the preferred embodiments of the invention. However, the drawings are not intended to imply limitation of the invention to a specific embodiment, but are for explanation and understanding only.

In the drawings:
FIG. 1A is a plan view schematically showing the first preferred embodiment of a liquid droplet ejecting apparatus according to the present invention;
FIG. 1B is an enlarged plan view showing a part of FIG. 1A;
FIG. 2 is a sectional view taken along line II-II of FIG. 1B;
FIG. 3 is an enlarged plan view showing a part of the second preferred embodiment of a liquid droplet ejecting apparatus according to the present invention;
FIG. 4 is a sectional view taken along line IV-IV of FIG. 3;
FIG. 5 is a plan view showing a part of an example of a mask for covering a photoresist film;
FIG. 6 is a sectional view showing a part of the third preferred embodiment of a liquid droplet ejecting apparatus according to the present invention, which corresponds to FIGS. 2 and 4;
FIG. 7 is an enlarged plan view of a part of the fourthpreferred embodiment of a liquid droplet ejecting apparatus according to the present invention;
FIG. 8 is a sectional view taken alone line VIII-VIII of FIG. 7;
FIGS. 9A through 9C are plan views showing examples of small holes of the fifth preferred embodiment of a liquid droplet ejecting apparatus according to the present invention; and
FIG. 10 is an enlarged sectional view of a part of a conventional liquid droplet ejecting apparatus.

### DESCRIPTION OF THE PREFERRED EMBODIMENTS

Referring now to the accompanying drawings, the preferred embodiments of the present invention will be described below in detail.

### [First Preferred Embodiment]

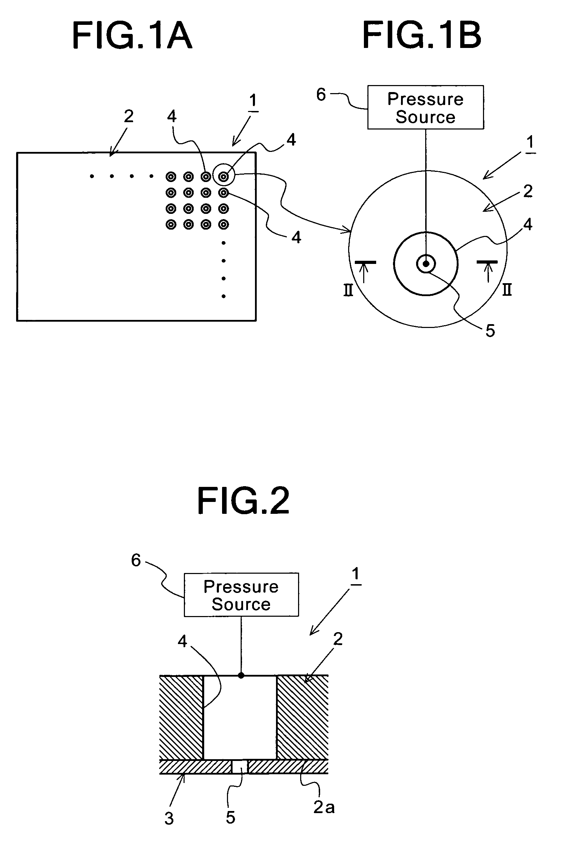

FIGS. 1A, 1B and 2 show the first preferred embodiment of a liquid droplet ejecting apparatus 1 according to the present invention. FIGS. 1A and 1B are plan views schematically showing the liquid droplet ejecting apparatus 1, and FIG. 2 is a sectional view taken along line II-II of FIG. 1B.

As shown in these figures, the liquid droplet ejecting apparatus 1 in this preferred embodiment comprises a flat-plate-shaped substrate 2, and a photoresist film 3 formed on one side (bottom side in FIG. 2) 2a of the substrate 2. The substrate 2 is formed of a plastic, glass, ceramic, silicon, metal or the like. The substrate 2 has a rectangular planar shape, and a thickness of 1 to 2 mm. The substrate 2 has a large number of through holes 4 which extend in thickness directions to pass through the substrate 2. Each of the holes 4 of the substrate 2 has a diameter of about 300 µm which is a few times as large as that of each of small holes 5 of the photoresist film 3, which will be described later. Each of the holes 4 of the substrate 2 serves as a liquid supply port, into which a liquid, such as a sample containing DNA fragments or an ink, is designed to be injected.

The photoresist film 3 is a super thick negative resist (e.g., a photoresist commercially available as TG-P series from Toyo Synthetic Industry Co., Ltd., or SU-8 fromMicrochemical Co., Ltd.) which is uniformly formed so as to have a thickness of about 100 µm. The photoresist film 3 has small holes (nozzles) 5 having a smaller diameter as that of each of the holes 4 of the substrate 2 so as to allow one end of each of the holes 4 to be open to the atmosphere. The diameter of each of the small holes 5 of the photoresist film 3 is about 100 µm. Thus, the inner surface of each of the small holes 5 serving as nozzles can be selectively formed so as to be hydrophobic or hydrophilic in accordance with the material of the used resist or with a process for the resist film, which is carried out if necessary.

The other end of each of the holes 4 of the substrate 2 is connected to a pressure source (e.g., an air pressure supply means comprising as a compressor and a valve) 6. If a pressure of the pressure source 6 is applied to a liquid injected into each of the holes 4 of the substrate 2, a small amount of liquid droplet is ejected from a corresponding one of the small holes 5 of the photoresist film 3, so that the ejected liquid drops and adheres to the surface of a slide glass or copy paper for forming a DNA chip (not shown). Furthermore, if the pressure of the pressure source 6 is simultaneously applied to all of the holes 4 of the substrate 2, a small amount of liquid is simultaneously ejected from all of the small holes 5. Alternatively, if the pressure of the pressure source 6 is designed to be selectively applied to any one of the large number of holes 4, the liquid can be ejected from only one of the small holes 5 corresponding to the one of the holes 4 to which the pressure of the pressure source 6 is applied.

A method for producing the liquid droplet ejecting apparatus 1 in this preferred embodiment will be described below.

First, a large number of holes 4 are formed in a substrate 2 by injection molding or machining (a first step). Then, a photoresist is formed on one side 2a of the substrate 2 by spin coating so as to have a thickness of about 100 µm, and after the spin coating of a photoresist film 3 is completed, the photoresist film 3 is dried at 100°C for about five minutes (a second step). Thereafter, the surface of the photoresist film 3 is covered with a mask (not shown) formed so as to shade portions in which small holes 5 are to be formed (a third step). Then, the surface of the photoresist film 3 is exposed (a fourth step). After this exposure is completed, the mask is removed from the surface of the photoresist film 3, and the photoresist film 3 is heated at 100°C for five to ten minutes. Then, the photoresist film 3 is dipped in a developing solution to remove non-exposed portions of the photoresist film 3 (portions shaded with the mask). Thus, the large number of small holes (nozzles) 5 having a diameter of about 100 µm can be simultaneously formed.

In the liquid droplet ejecting apparatus 1 in this preferred embodiment as described above, the holes 4 of the substrate 2 serving as the liquid supply ports are closed with the photoresist films 3, and the small holes 5 serving as the nozzles are formed in the photoresist films 3, so that the large number of small holes 5 can be simultaneously formed with the developing solution. Therefore, it is possible to enhance the production efficiency, and it is possible to reduce the production costs.

While various numerical values, producing conditions and so forth in this preferred embodiment have been disclosed as examples in order to facilitate better understanding of the present invention, it should not be limited thereto, but the optimum dimensions, producing conditions and so forth may be set in accordance with design conditions and so forth.

While the photoresist film 3 has been described as an example of a resist film in the above described preferred embodiment, the present invention should not be limited thereto, but a far ultraviolet radiation resist film, an X-ray resist film or an electron beam resist film may be substituted for the photoresist film 3. In addition, while the photoresist film 3 has been made of the high polymer resist as an example in the above described preferred embodiment, it may be made of an inorganic resist. Moreover, while the negative resist has bee used as an example in the above descried preferred embodiment, a positive resist may be used.

The thickness of the photoresist film 3 should not be limited to 100 µm which has been described as an example in the above described preferred embodiment, but the optimum numerical value may be selected in the range of 1 to 1000 µm.

The diameter of each of the small holes 5 should not be limited to 100 µm which has been described as an example in the above described preferred embodiment, but the optimum numerical value may be selected in the range of 1 to 1000 µm (preferably in the range of 10 to 500 µm).

### [Second Preferred Embodiment]

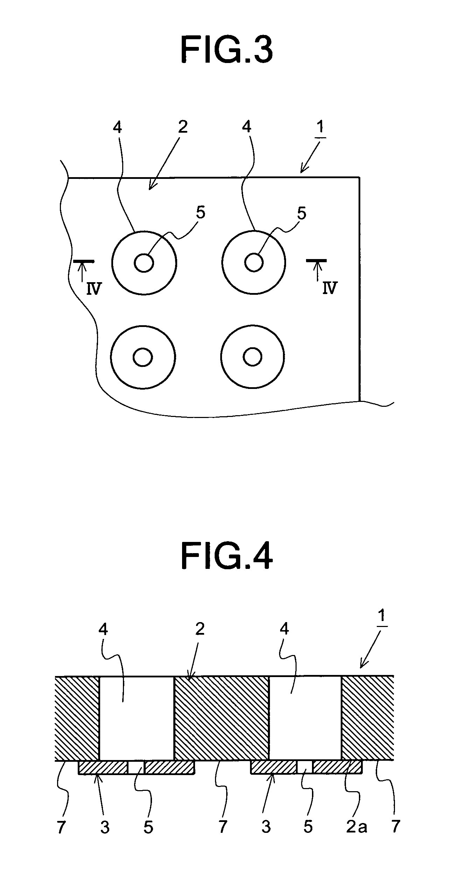

FIGS. 3 and 4 show the second preferred embodiment of a liquid droplet ejecting apparatus according to the present invention, which show a modified example of the above described first preferred embodiment. FIG. 3 is an enlarged plan view of a part of the second preferred embodiment of a liquid droplet ejecting apparatus according to the present invention, and FIG. 4 is a sectional view taken along line IV-IV of FIG. 3.

According to this preferred embodiment, portions of a photoresist film 3 corresponding to small holes 5 are removed, and peripheral portions 7 of the photoresist film 3 except for portions near the opening edges of holes 4 of a substrate 2 are removed. As a result, in FIG. 4, disk-shaped photoresist films 3, each of which has a small hole 5 at its center, are separately fixed to the bottom side 2a of the substrate 2 so as to correspond to the holes 4. Each of the photoresist films 3 serves as a lid member for closing one end (the bottom side 2a) of a corresponding one of the holes 4 of the substrate 2. Each of the small holes 5 decreases the opening area of the one end (on the bottom side 2a) of the corresponding one of the holes 4, and allows the one end of the corresponding one of the holes 4 to be open to the atmosphere.

With this construction, the photoresist films 3 are separately fixed to the bottom side 2a of the substrate 2. Therefore, even if a liquid adheres to a portion near the opening edge of one of the small holes 5, the liquid does not reach adjacent one of the small holes 5 via the surface of the photoresist films 3, so that it is possible to effectively prevent the liquid from being mixed with a liquid in the adjacent one of the small holes 5. Therefore, according to this preferred embodiment, in addition to the advantageous effects of the above described first preferred embodiment, it is possible to prevent liquids, which are ejected from adjacent two of the small holes 5, from being mixed with each other, and it is possible to more precisely eject liquid droplets.

A method for producing the liquid droplet ejecting apparatus 1 in this preferred embodiment will be described below.

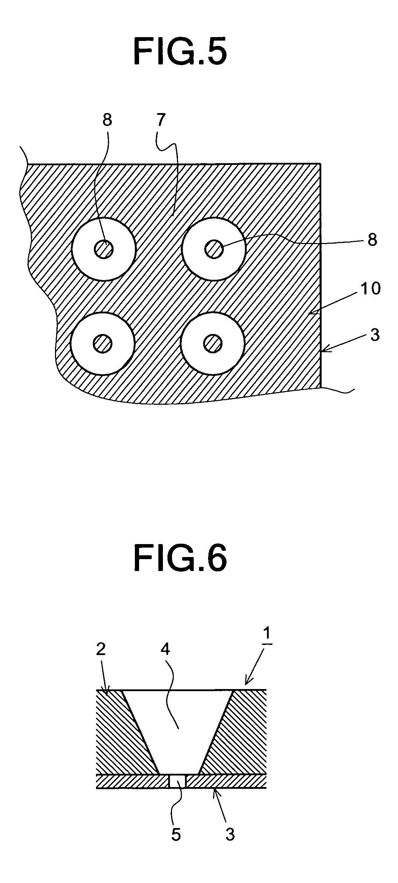

First, a large number of holes 4 are formed in a substrate 2 by injection molding or machining (a first step). Then, a photoresist is formed on one side 2a of the substrate 2 by spin coating so as to have a thickness of about 100 µm, and after the spin coating of a photoresist film 3 is completed, the photoresist film 3 is dried at 100°C for about five minutes (a second step). Thereafter, as shown in FIG. 5, the surface of the photoresist film 3 is covered with a mask 10 formed so as to shade portions (portions 8 shown by slanting lines), in which small holes 5 are to be formed, and peripheral portions (portions 7 shown by slanting lines) expect for portions near the opening edges of the holes 4 of the substrate 2 (a third step). Then, the surface of the photoresist film 3 is exposed (a fourth step). After this exposure is completed, the mask 10 is removed from the surface of the photoresist film 3, and the photoresist film 3 is heated at 100°C for five to ten minutes. Then, the photoresist film 3 is dipped in a developing solution to remove non-exposed portions of the photoresist film 3 (portions 7 and 8 shaded with the mask). Thus, a large number of disk-shaped photoresist films 3, each of which has a small hole 5 at its center, are simultaneously formed so as to correspond to the holes 4 of the substrate 2 and so as to be isolated from each other as floating islands.

### [Third Preferred Embodiment]

FIG. 6 is a sectional view showing a part of the third preferred embodiment of a liquid droplet ejecting apparatus 1 according to the present invention, which corresponds to FIGS. 2 and 4.

In the preferred embodiment shown in FIG. 6, truncated conical holes 4 are formed in a substrate 2 so that the diameter of each of the holes 4 increases as a distance from a corresponding one of small holes 5 of a photoresist film 3 increases. Thus, the upper opening portion of each of the holes 4 is as large as possible, so that the volume of each of the holes 4 is greater than that of each of the substantially cylindrical holes 4 shown in FIGS. 2 and 4.

### [Fourth Preferred Embodiment]

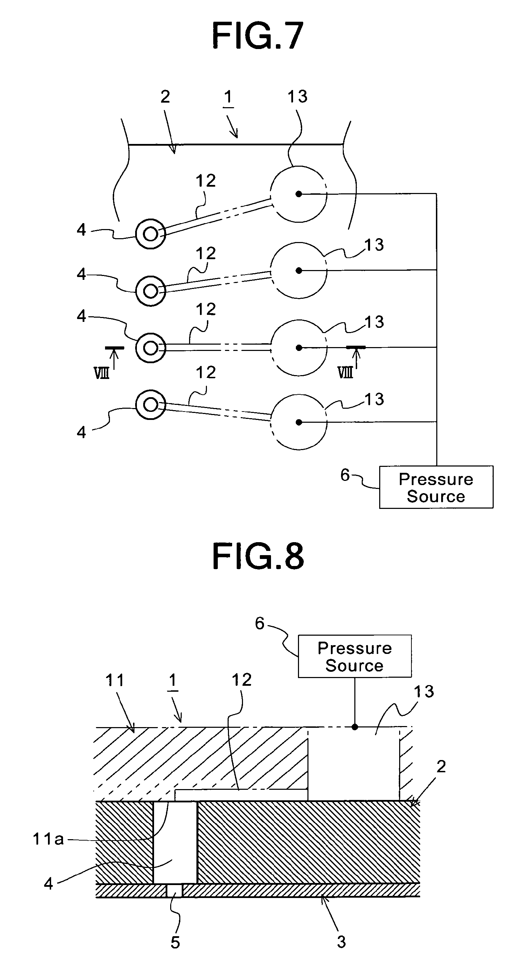

FIGS. 7 and 8 show the fourth preferred embodiment of a liquid droplet ejecting apparatus 1 according to the present invention, which show a modified example of the liquid droplet ejecting apparatus 1 shown in FIGS. 1A, 1B and 2. FIG. 7 is an enlarged plan view showing a part of the liquid droplet ejecting apparatus 1, and FIG. 8 is a sectional view taken along line VIII-VIII of FIG. 7.

As shown in these figures, in this preferred embodiment, an upper plate 11 is bonded to the top face of a substrate 2, and fine communication passages 12, one end of each of which is open to a corresponding one of holes 4 of the substrate 2, are formed on the bottom side (in a surface bonded to the substrate) 11a of the upper plate 11. The other end of each of the communication passages 12 formed in the upper plate 11 is open to a reservoir 13, which is formed in the upper plate 11, so as to establish a communication between the reservoir 13 and the corresponding one of the holes 4. A liquid supplied to the reservoir 13 passes through a corresponding one of the communication passages 12 to enter the corresponding one of the holes 4 to be fed into a corresponding one of small holes 5 of a photoresist film 3 due to capillarity. In this state, if the liquid in the reservoir 13 is pressurized by the pressure of the pressure source 6, a small amount of liquid is ejected from the corresponding one of small holes 5 of the photoresist film 3.

According to such a preferred embodiment, in addition to the same advantageous effects as those of the liquid droplet ejecting apparatus 1 shown in FIGS. 1A, 1B and 2, it is possible to decrease the diameter of each of the holes 4 of the substrate 2, and it is possible to enhance the density of arrangement of the small holes 5 of the photoresist film 3.

### [Fifth Preferred Embodiment]

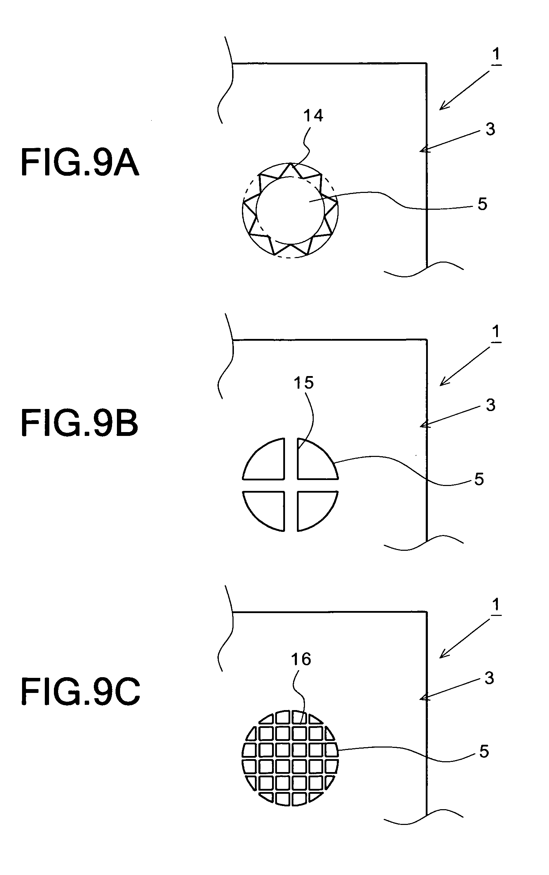

FIGS. 9A through 9C show the shape of each of small holes 5 of a photoresist film 3 of the fifth preferred embodiment of a liquid droplet ejecting apparatus 1 according to the present invention, which show various modified examples of the shape of each of the small holes 5 shown in FIG. 1B. That is, the planar shape of each of the small holes 5 of FIG. 1B is a substantially circle. On the other hand, each of the small holes 5 in the fifth preferred embodiment shown in FIG. 9A has a plurality of radial grooves 14 arranged in circumferential directions so as to increase the surface area of the inner surface of each of the small holes 5. According to such a preferred embodiment, the surface tension in each of the small holes 5 increases to increase force acquiring a liquid in each of the small holes 5, so that it is possible to effectively prevent the liquid from being leaked out of the corresponding one of the small holes 5.

Furthermore, the shape of each of the small holes 5 should not be limited to the shape shown in FIG. 9A. For example, the inner surface of each of the small holes 5 may be regularly or irregularly roughened to increase the surface area of the inner surface thereof. Alternatively, as shown in FIG. 9B, each of small holes 5 having a substantially circular planar shape may be divided into four holes by a cross partition wall 15. As shown in FIG. 9C, each of small holes 5 having a substantially circular planar shape may be divided into a large number of holes by a lattice-shaped partition wall 16. The planar shape of each of small holes 5 may be triangular, rectangular or elliptical, although they are not shown. Each of small holes 5 may be a plurality of very small triangular holes, a plurality of very small rectangular holes, or a plurality of very small elliptical holes, although they are not shown.

A liquid droplet ejecting apparatus according to the present invention can be used as an ink ejecting apparatus of an ink jet printer, as well as a spotting apparatus for applying a liquid droplet (a liquid sample) containing DNA fragments on a DNA chip or the like.

## Claims

1. A liquid droplet ejecting apparatus comprising:
a substrate having a through hole which extends in thickness directions to pass through the substrate; and
a resist film formed on one side of said substrate to close one end of said through hole of said substrate,
wherein said resist film has a small hole which faces said one end of said through hole to open said one end of said through hole to the atmosphere, and
a droplet of a liquid is ejected from said small hole when a pressure is applied to the other end of said through hole after said liquid is injected into said through hole.

2. A liquid droplet ejecting apparatus comprising:
a substrate having a plurality of through holes, each of which extends in thickness directions to pass through the substrate; and
a plurality of lid members of a resist film, each of said lid members being formed on one side of said substrate to close one end of a corresponding one of said through holes of said substrate,
wherein each of said lid members has a small hole which faces said one end of said corresponding one of said through holes to open said one end of said corresponding one of said through holes to the atmosphere, and
a droplet of a liquid is ejected from said small hole of a corresponding one of said lid members when a pressure is applied to the other end of a corresponding one of said through holes after said liquid is injected into said corresponding one of said through holes.

3. A method for producing a liquid droplet ejecting apparatus, said method comprising the steps of:
forming a through hole in a substrate so that the through hole extends in thickness directions to pass through the substrate;
forming a resist film on one side of said substrate to close one end of said through hole of said substrate;
covering a portion of said resist film with a mask which has such a shape that a small hole is formed in said resist film to open said one end of said through hole to the atmosphere;
exposing said resist film after said portion of said resist film is covered with said mask; and
removing a portion of said resist film, which is not exposed, to form said small hole in said resist film.

4. A method for producing a liquid droplet ejecting apparatus, said method comprising the steps of:
forming a plurality of through holes in a substrate so that each of the through holes extends in thickness directions to pass through the substrate;
forming a resist film on one side of said substrate to close one end of each of said through holes of said substrate;
covering portions of said resist film with a mask which has such a shape that a plurality of lid members of said resist film are formed to close said one end of each of said through holes, respectively, and that a plurality of small holes are formed in said lid members to open said one end of each of said through holes to the atmosphere, respectively;
exposing said resist film after said portions of said resist film are covered with said mask; and
removing portions of said resist film, which are not exposed, to form said small holes in said lidmembers, respectively.
